# EUROPEAN PATENT APPLICATION

(11) **EP 4 808 312 A1**
(43) Date of publication of application: **16.09.2026**
(21) Application number: 25212441.7
(22) Date of filing: 30.10.2025
(51) Int. Cl.: H10F 19/90, H10F 77/20

(54) **PHOTOVOLTAIC MODULE**

(30) Priority: 10.03.2025 CN 202510281343
(71) Applicant: Jinko Solar (Haining) Co., Ltd., Haining City, Zhejiang 314415 (CN)
(72) Inventor: TAO, Wusong, Haining, 314415 (CN); WANG, Luchuang, Haining, 314415 (CN); HAN, Xiangchao, Haining, 314415 (CN); SONG, Yongqiao, Haining, 314415 (CN)
(74) Representative: DREISS Patentanwälte PartG mbB

(57) **Abstract**

Provided is a photovoltaic module, including a solar cell and a solder strip. A plurality of solar cells are arranged along a first direction, and there is overlap between projections of two adjacent solar cells along a second direction, and the two adjacent solar cells are connected by the solder strip. The solar cell includes a first surface and a second surface along the second direction. A first busbar is provided on the first surface and includes a first current collecting unit. A second busbar is provided on the second surface and includes a second current collecting unit. Along the second direction, a projection area of the first current collecting unit is smaller than a projection area of the second current collecting unit, and a projection of the first current collecting unit is located within a projection of the solder strip corresponding thereto. By this design, the shading area of the first current collecting unit is reduced to improve the photovoltaic conversion efficiency of the photovoltaic module. The second current collecting unit is provided on the second surface of the solar cell, with an area larger than that of the first current collecting unit, which increases the current-collecting capability of the second current collecting unit and reduces the risk of shading loss caused by the second current collecting unit on the solar cell.

## Description

### TECHNICAL FIELD

The present disclosure relates to the field of photovoltaic technology, and in particular, to a photovoltaic module.

### BACKGROUND

A photovoltaic module plays a role in conversion of received solar energy into electrical energy. Currently, the photovoltaic efficiency of the photovoltaic module is relatively low, which affects the reliability of the photovoltaic module.

### SUMMARY

In view of the above, a photovoltaic module is provided herein for facilitating solution of the problem of low photovoltaic conversion efficiency of photovoltaic modules in the existing technology.

One or more embodiments of the present disclosure provides a photovoltaic module, including a solar cell and a solder strip. A plurality of solar cells are arranged along a first direction, and there is overlap between projections of two adjacent solar cells along a second direction, and the two adjacent solar cells are connected by the solder strip. The solar cell includes a first surface and a second surface along the second direction. A first busbar is provided on the first surface and includes a first current collecting unit. A second busbar is provided on the second surface and includes a second current collecting unit. Along the second direction, a projection area of the first current collecting unit is smaller than a projection area of the second current collecting unit, and a projection of the first current collecting unit is located within a projection of the solder strip corresponding thereto.

In one or more embodiments, the first busbar includes a first main body connected to the solder strip. The first current collecting unit is connected to at least one end of the first main body. The projection of the first current collecting unit along the second direction exhibits a linear form. An arrangement direction of the first current collecting unit is the same as an arrangement direction of the first main body.

In one or more embodiments, the first current collecting unit is connected to two ends of the first main body, and the first current collecting unit and the first main body are connected to the same solder strip.

In one or more embodiments, along the second direction, a projection of at least part of the second current collecting unit is located outside a projection of the solder strip corresponding thereto.

In one or more embodiments, the second busbar includes a second main body connected to the solder strip. The second current collecting unit is connected to at least one end of the second main body. The second current collecting unit includes a first current collecting segment and a second current collecting segment that are connected to each other, and a distance between the first current collecting segment and the second current collecting segment gradually increases in a direction away from the second main body.

In one or more embodiments, the maximum distance between the first current collecting segment and the second current collecting segment is W1, a width of the solder strip is W2, and W1 and W2 satisfy: W1>W2.

In one or more embodiments, the photovoltaic module includes a buffer. Along the second direction, the buffer is provided between the two adjacent solar cells.

In one or more embodiments, along the second direction, a projection area of the buffer is larger than an overlap area of the projections of the two adjacent solar cells.

In one or more embodiments, a length of the buffer is the same as a length of the solar cell, and a thickness D of the buffer satisfies: 50 µm ≤ D ≤ 200 µm.

In one or more embodiments, the two adjacent solar cells are respectively a first solar cell and a second solar cell. The buffer is provided at a side of the solder strip facing the second surface of the first solar cell, and/or the buffer is provided at a side of the solder strip facing the first surface of the second solar cell.

One or more embodiments of the present disclosure provides a photovoltaic module, including a solar cell and a solder strip. A plurality of solar cells are arranged along a first direction, and there is overlap between projections of two adjacent solar cells along a second direction, and the two adjacent solar cells are connected by the solder strip. The solar cell includes a first surface and a second surface along the second direction. A first busbar is provided on the first surface and includes a first current collecting unit. A second busbar is provided on the second surface and includes a second current collecting unit. Along the second direction, a projection area of the first current collecting unit is smaller than a projection area of the second current collecting unit, and a projection of the first current collecting unit is located within a projection of the solder strip corresponding thereto. By reducing the area of the first current collecting unit on the first surface, the shading area of the first current collecting unit is thus reduced. The projection of the first current collecting unit is located within the projection of the solder strip corresponding thereto, preventing the first current collecting unit from shading the regions of the solar cell outside the solder strip, thereby increasing the area of the first surface of the solar cell that receives light, and consequently improving the photovoltaic conversion efficiency of the photovoltaic module. The area of the second current collecting unit is larger than the area of the first current collecting unit. By providing the second current collecting unit on the second surface of the solar cell, the current-collecting capability of the second current collecting unit is increased, while the risk of shading loss caused by the second current collecting unit on the solar cell is reduced. Furthermore, during string soldering of the solar cells, since the projection of the first current collecting unit is located within the projection of the solder strip corresponding thereto, the solder strip is soldered to the entire first current collecting unit. That is, the entire first current collecting unit is alloyed with the solder strip, enabling the current collected by the first current collecting unit to be directly transmitted to the solder strip, thereby reducing the current transmission path, and lowering current transmission loss, which also improves the photovoltaic conversion efficiency of the photovoltaic module.

It should be understood that the foregoing general description and the following detailed description are merely illustrative and are not intended to limit the present disclosure.

### BRIEF DESCRIPTION OF DRAWINGS

In order to better illustrate the technical solutions in embodiments of the present disclosure, the drawings used in the description of embodiments are briefly described as below.
FIG. 1 is a schematic diagram of a photovoltaic module according to one or more embodiments of the present disclosure;
FIG. 2 is a schematic diagram of solar cells connected by a solder strip according to one or more embodiments of the present disclosure;
FIG. 3 is a schematic diagram of a first surface of a solar cell according to one or more embodiments of the present disclosure;
FIG. 4 is a schematic diagram of a second surface of a solar cell according to one or more embodiments of the present disclosure;
FIG. 5 is an enlarged view of part I in FIG. 3;
FIG. 6 is an enlarged view of part II in FIG. 4;
FIG. 7 is a partial schematic diagram of connection between a solar cell and a solder strip according to one or more embodiments of the present disclosure;
FIG. 8 is a schematic diagram of a solar cell and a buffer according to one or more embodiments of the present disclosure; and
FIG. 9 is a schematic diagram of solar cells connected by a solder strip according to further one or more embodiments of the present disclosure.

### Reference signs:

1000 - photovoltaic module;
100 - solar cell layer;
10 - solar cell;
   10a - first surface;
   10b - second surface;
   11 - first busbar;
      111 - first current collecting unit;
      112 - first main body;
   12 - second busbar;
      121 - second current collecting unit;
         1211 - first current collecting segment;
            1211a - first end;
         1212 - second current collecting segment;
            1212a - second end;
      122 - second main body;
   13 - buffer;
20 - solder strip;
200 - cover plate;
300 - first adhesive film layer;
400 - second adhesive film layer;
500 - back sheet;
W1 - maximum distance between the first current collecting segment and the second current collecting segment;
W2 - width of the solder strip.

### DESCRIPTION OF EMBODIMENTS

In order to better understand the technical solutions of the present disclosure, embodiments of the present disclosure are described in detail below in conjunction with the drawings.

The terms used in embodiments of the present disclosure are only for the purpose of describing specific embodiments, and are not intended to limit the present disclosure. As used in embodiments of the present disclosure and the appended claims, the singular forms "a/an", "said", and "the" are intended to include the plural forms as well, unless the context clearly indicated otherwise.

It should be understood that the term "and/or" used herein is merely an association relationship describing an associated object, indicating that there may be three relationships, for example, A and/or B, and may indicate: only A, both A and B, and only B. In addition, the character "/" herein generally indicates that the related objects before and after the character present an "or" relationship.

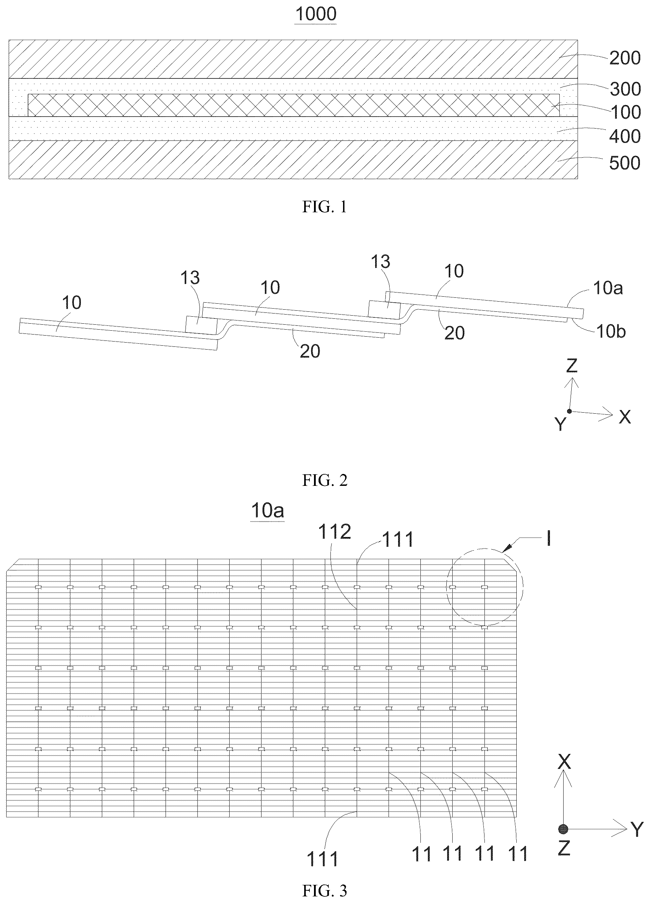

As shown in FIG. 1, one or more embodiments of the present disclosure provides a photovoltaic module 1000. The photovoltaic module 1000 includes a cover plate 200, a first adhesive film layer 300, a solar cell layer 100, a second adhesive film layer 400, and a back sheet 500. The cover plate 200, the first adhesive film layer 300, the solar cell layer 100, the second adhesive film layer 400, and the back sheet 500 are arranged along the thickness direction of the photovoltaic module 1000 and laminated together. The cover plate 200 is a glass cover plate with a high light transmittance. The first adhesive film layer 300 bonds the cover plate 200 to the solar cell layer 100 to provide encapsulation and protection for the solar cell layer 100. A material of the first adhesive film layer 300 is one or more of ethylene-vinyl acetate (EVA), polyolefin elastomer (POE), and polyvinyl butyral (PVB). In combination with FIG. 2, the solar cell layer 100 includes at least one solar cell string, and the solar cell string includes a plurality of electrically connected solar cells 10 that convert solar energy into electrical energy. The second adhesive film layer 400 connects the solar cell layer 100 to the back sheet 500 and also provides encapsulation and protection for the solar cell layer 100. A material of the second adhesive film layer 400 is one or more of the above EVA, POE, and PVB. A material of the back sheet 500 is glass, or the back sheet 500 is compounded of multiple polymer film layers.

The solar cell is obtained by cutting whole cells into half-segmented cell, three-segmented cell, four-segmented cell, or eight-segmented cell. That is, the solar cell is a segmented cell.

A type of the solar cell includes, but are not limited to, passivated emitter and rear cell (PERC), tunnel oxide passivated contact (TOPCon) cell, heterojunction with intrinsic thin-film (HJT) cell, perovskite solar cell, etc.

For a PERC, along its thickness direction, the PERC includes a front-surface metal silver electrode, a front-surface silicon nitride passivation layer, a phosphorus layer emitter, a P-type silicon substrate layer, a local aluminum rear field, a metal aluminum rear electrode, and a rear passivation layer (Al₂O₃/SiNₓ) in sequence. PERC employs a passivation film for passivating the rear to replace the full aluminum rear field, thereby enhancing internal rear reflection of light in the silicon substrate, reducing the recombination rate at the rear, and increasing the efficiency of the solar cell by 0.5%-1%.

For a TOPCon cell, along its thickness direction, the TOPCon cell includes a metal silver electrode, a front-surface silicon nitride passivation layer, a boron-doped emitter, an N-type silicon substrate layer, a diffusion-doped layer, an ultrathin silicon oxide layer, doped polysilicon, silicon nitride, and a metal silver electrode in sequence. The rear of the cell is composed of an ultrathin silicon oxide layer (1 nm to 2 nm) and a phosphorus-doped microcrystalline-amorphous mixed silicon thin film, which together form a passivated contact structure that suppress the recombination of minority carrier holes, thereby increasing the open-circuit voltage and short-circuit current of the cell. The ultrathin oxide layer allows majority carrier electrons to tunnel into the polysilicon layer while suppressing the recombination of minority carrier holes. The excellent passivation effect of the ultrathin silicon oxide and heavily doped silicon film causes surface band bending of the silicon wafer, so as to arrive a field passivation effect, which significantly increases the probability of electron tunneling, reduces contact resistance, and improves the open-circuit voltage and short-circuit current of the solar cell, thereby improving the conversion efficiency of the solar cell.

For a HJT cell, along its thickness direction, the HJT cell includes a front low-temperature silver electrode, a front conductive thin film, an N-type amorphous silicon thin film, an intrinsic amorphous silicon thin film, an N-type silicon substrate layer, an intrinsic amorphous silicon thin film, a P-type amorphous silicon thin film, a rear conductive thin film, and a rear low-temperature silver electrode in sequence.

For a perovskite solar cell, along its thickness direction, the perovskite solar cell includes a substrate material, a conductive thin film, an electron transport layer (titanium dioxide), a perovskite absorption layer (hole transport layer), and a metal cathode in sequence. Perovskite material has a high light absorption coefficient and a long carrier diffusion distance. After the photons absorbed by the perovskite material are converted into electrons, they are easily collected by the electrodes with less loss, thereby generating a high photovoltage and photocurrent, and resulting in a high photovoltaic conversion efficiency for the perovskite solar cell.

The surface of the solar cell is provided with grid lines including busbars and fingers that are intersecting (typically perpendicular) to each other. The busbars and the fingers are usually formed by printing and sintering metal paste (such as silver paste). The fingers are used to collect and conduct current on the solar cell, and the busbars are used to collect current in the fingers for convergence. In order to improve the power generation efficiency of the photovoltaic module and reduce costs, the solar cell is a multi-busbar (MBB) solar cell. That is, multiple busbars are printed on the surface of the solar cell. By increasing the number of busbars, the multi-busbar technology correspondingly reduces the number of fingers and reduce costs. Furthermore, the current conduction path between the busbar and the finger is also shorten to reduce power loss and thus increase the power of the solar cell.

As shown in FIG. 2, in one or more embodiments of the present disclosure, a plurality of solar cells 10 are arranged along a first direction X, and there is overlap between projections of two adjacent solar cells 10 along a second direction Z, and the area of the overlap is smaller than the area of the solar cell 10. The first direction X is the width direction of the solar cell 10, and the second direction Z is the thickness direction of the solar cell 10. In some embodiments, along the second direction Z, one of the two adjacent solar cells 10 is stacked on one side of the other, and there is overlap between projections of the ends of the two solar cells 10. That is, the ends of the two adjacent solar cells 10 are stacked together, so as to allow shingled arrangement of the plurality of solar cells 10, thereby reducing the spacing between the solar cells 10, increasing the arrangement density of the solar cells 10 in the photovoltaic module 1000, and consequently increasing the power of the photovoltaic module 1000.

The solar cell 10 includes a first surface 10a and a second surface 10b along the second direction Z. The first surface 10a is the light-receiving surface of the solar cell 10, i.e., the surface that is directly irradiated by sunlight, and the second surface 10b is the backlight surface of the solar cell 10, i.e., the surface that is not directly irradiated by sunlight. Both the first surface 10a and the second surface 10b receive sunlight and convert light energy into electrical energy.

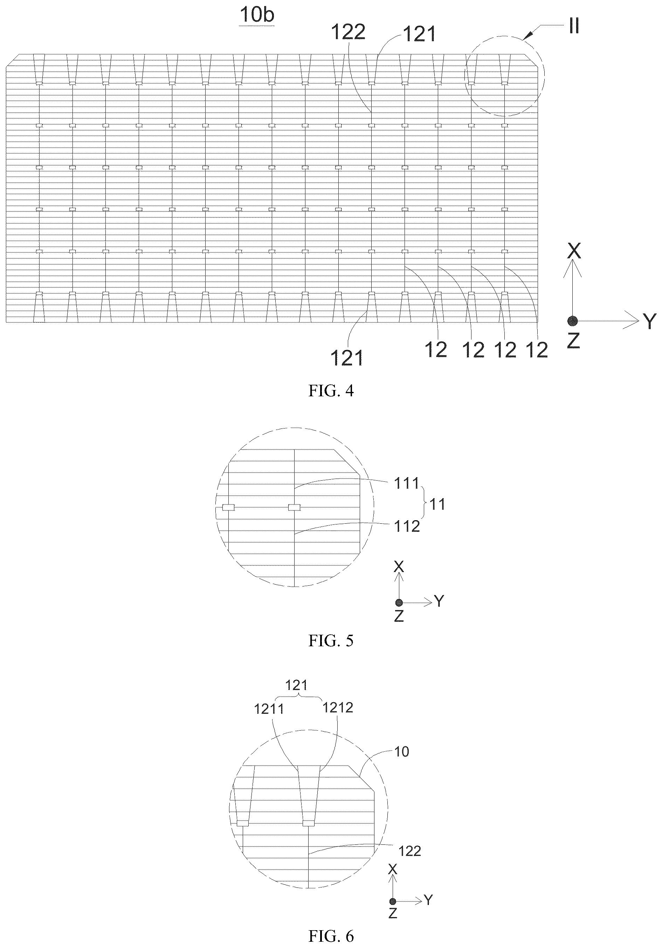

Referring to FIG. 3 and FIG. 4, a first busbar 11 is provided on the first surface 10a, and a second busbar 12 is provided on the second surface 10b. The first busbar 11 and the second busbar 12 are arranged at intervals along a third direction Y, where the third direction Y is the length direction of the solar cell 10. Two adjacent cells 10 are connected by the solder strip 20 that is arranged in a one-to-one correspondence with the first busbar 11 and the second busbar 12. In some embodiments, one solder strip 20 is connected to the first busbar 11 of one solar cell 10 and the second busbar 12 of another solar cell 10, so as to achieve electrical connection between the two solar cells 10.

The first busbar 11 includes a first current collecting unit 111, and the second busbar 12 includes a second current collecting unit 121. Both the first current collecting unit 111 and the second current collecting unit 121 are provided at edge of the solar cell 10 for collecting current at the edge of the solar cell 10. Along the second direction Z, the projection area of the first current collecting unit 111 is smaller than the projection area of the second current collecting unit 121, and the projection of the first current collecting unit 111 is located within the projection of the solder strip 20 corresponding thereto.

By reducing the area of the first current collecting unit 111 on the first surface 10a, the shading area of the first current collecting unit 111 is thus reduced. Furthermore, the projection of the first current collecting unit 111 is located within the projection of the solder strip 20 corresponding thereto. That is, the solder strip 20 completely covers the first current collecting unit 111, preventing the first current collecting unit 111 from shading the regions of the solar cell 10 outside the solder strip 20, thereby increasing the area of the first surface 10a of the solar cell 10 that receives light, and consequently improving the photovoltaic conversion efficiency of the photovoltaic module 1000. The area of the second current collecting unit 121 is larger than the area of the first current collecting unit 111. By providing the second current collecting unit 121 on the second surface 10b of the solar cell 10, the current-collecting capability of the second current collecting unit 121 is increased, while the risk of shading loss caused by the second current collecting unit 121 on the solar cell 10 is reduced. Furthermore, during string soldering of the solar cells 10, since the projection of the first current collecting unit 111 is located within the projection of the solder strip 20 corresponding thereto, the solder strip 20 is soldered to the entire first current collecting unit 111. That is, the entire first current collecting unit is alloyed with the solder strip 20, enabling the current collected by the first current collecting unit 111 to be directly transmitted to the solder strip 20, thereby reducing the current transmission path, and lowering current transmission loss, which also improves the photovoltaic conversion efficiency of the photovoltaic module 1000.

As shown in FIG. 2, FIG. 3 and FIG. 5, in one or more embodiments, the first busbar 11 includes a first main body 112 connected to the solder strip 20. The first current collecting unit 111 is connected to at least one end of the first main body 112. The projection of the first current collecting unit 111 along the second direction Z exhibits a linear form. The arrangement direction of the first current collecting unit 111 is the same as the arrangement direction of the first main body 112.

The first main body 112 and the first current collecting unit 111 are both arranged along the first direction X, and the projections of the first main body 112 and the first current collecting unit 111 along the second direction Z both exhibit a linear form. The first main body 112 also serves to collect current. Along the first direction X, the first current collecting unit 111 is connected to one or two ends of the first main body 112. The first current collecting unit 111 and the first main body 112 are integrally formed. In some embodiments, the first current collecting unit 111 and the first main body 112 are both formed by printing and sintering metal paste.

The first current collecting unit 111 is designed in a linear form to achieve current collection function while reducing the shading area of the first current collecting unit 111, thereby increasing the area of the first surface 10a of the solar cell 10 that receives light, and consequently improving the photovoltaic conversion efficiency of the photovoltaic module 1000. Furthermore, the shape of the first current collecting unit 111 is the same as the shape of the first main body 112, and the arrangement direction of the first current collecting unit 111 is the same as the arrangement direction of the first main body 112, which improve the structure stability of the first busbar 11, reduce the risk of breakage of the first busbar 11 caused by stress concentration at the connection between the first current collecting unit 111 and the first main body 112, and facilitate the printing of metal paste to simplify the production process of the photovoltaic module 1000.

In some embodiments, the width of the first current collecting unit 111 is the same as the width of the first main body 112 to facilitate the preparation of the first busbar 11.

In some embodiments, the width of the first current collecting unit 111 is greater than the width of the first main body 112. By increasing the width of the first current collecting unit 111, the area for collecting current of the first current collecting unit 111 is increased, that is, the current-collecting capability of the first current collecting unit 111 is enhanced, thereby improving the capability of the first busbar 11 to collect current at the edge of the solar cell 10, and consequently improving the photovoltaic conversion efficiency of the photovoltaic module 1000.

As shown in FIG. 2, FIG. 3 and FIG. 5, in one or more embodiments, the first current collecting unit 111 is connected to two ends of the first main body 112, and the first current collecting unit 111 and the first main body 112 are connected to the same solder strip 20.

The first current collecting unit 111 is connected to two ends of the first main body 112 along the first direction X, so that the first busbar 11 exhibits a linear structure. The solder strip 20 is connected to the first main body 112 and the first current collecting unit 111 by soldering. In some embodiments, the solder strip 20 is connected to the first main body 112 and the first current collecting unit 111 by high-temperature soldering. During the soldering, the metal (e.g., tin) in the solder strip 20 undergoes an alloying reaction with the metal (e.g., silver) in the first current collecting unit 111 and the first main body 112, so that the solder strip 20 is alloyed with the first current collecting unit 111 and the first main body 112, enabling the current collected by the first current collecting unit 111 to be directly transmitted to the solder strip 20 without transit by the first main body portion 112, thereby reducing the current transmission path, lowering current transmission loss, and improving the photovoltaic conversion efficiency of the photovoltaic module 1000. Furthermore, the first current collecting unit 111 exhibits a linear structure, enabling the first current collecting unit 111 to form a stable connection structure with the solder strip 20, thereby reducing the risk of hidden cracks or breakage in the solar cell 10 caused by stress concentration at the first current collecting unit 111 of the solar cell 10.

As shown in FIG. 2 and FIG. 4, in one or more embodiments, along the second direction Z, the projection of at least part of the second current collecting unit 121 is located outside the projection of the solder strip 20 corresponding thereto.

Along the second direction Z, the projection of the entire second current collecting unit 121 is located outside the projection of the solder strip 20 corresponding thereto, or the projection of part of the second current collecting unit 121 is located outside the projection of the solder strip 20 corresponding thereto. By this design, during string soldering of the solar cells 10, a part of or the entire second current collecting unit 121 is not connected to the solder strip 20, enabling the solder strip 20 to be in a movable state at an edge of the solar cell 10 (i.e., at the position where the second current collecting unit 121 is provided). That is, the edge of the solar cell 10 is not fixed by the solder strip 20, reducing the risk of stress concentration at the edge of the solar cell 10 during lamination, testing, transportation and other processes, thereby reducing the risk of hidden cracks or breakage in the solar cell 10, and improving the overall reliability of the photovoltaic module 1000.

As shown in FIG. 2, FIG. 4 and FIG. 6, in one or more embodiments, the second busbar 12 includes a second main body 122 connected to the solder strip 20. The second current collecting unit 121 is connected to at least one end of the second main body 122. The second current collecting unit 121 includes a first current collecting segment 1211 and a second current collecting segment 1212 that are connected to each other, and the distance between the first current collecting segment 1211 and the second current collecting segment 1212 gradually increases in the direction away from the second main body 122.

The second current collecting unit 121 is connected to at least one end of the second main body 122 along the first direction X. The arrangement direction of the second main body 122 is different from the arrangement direction of the first current collecting segment 1211 or the arrangement direction of the second current collecting segment 1212, enabling the second main body 122, the first current collecting segment 1211, and the second current collecting segment 1212 to be connected approximately in a Y-shaped form. The first current collecting segment 1211 and the second current collecting segment 1212 extend toward the edge of the solar cell 10 along different directions, respectively, and the distance between the first current collecting segment 1211 and the second current collecting segment 1212 gradually increases in the direction away from the second main body 122, enabling them to be connected to form a harpoon structure approximately in a V-shaped or a U-shaped form.

By providing the first current collecting segment 1211 and the second current collecting segment 1212, the second current collecting unit 121 more effectively collects the current at the edge of the solar cell 10, thereby improving the capability of the second busbar 12 to collect current at the edge of the solar cell 10, improving the performance of the solar cell 10, and consequently improving the photovoltaic conversion efficiency of the photovoltaic module 1000.

In some embodiments, the width of the first current collecting segment 1211 and the width of the second current collecting segment 1212 are the same as the width of the second main body 122 to facilitate the preparation of the second busbar 12.

In some embodiments, the width of the first current collecting segment 1211 and the width of the second current collecting segment 1212 are greater than the width of the second main body 122. By increasing the width of the first current collecting segment 1211 and the second current collecting segment 1212, the area for collecting current of the second current collecting unit 121 is increased, that is, the current-collecting capability of the second current collecting unit 121 is enhanced, thereby improving the capability of the second busbar 12 to collect current at the edge of the solar cell 10, and consequently improving the photovoltaic conversion efficiency of the photovoltaic module 1000.

In some embodiments, the first busbar includes a first main body, a first current collecting unit, and a third current collecting unit. Along the second direction, the first current collecting unit and the third current collecting unit are connected to two ends of the first main body, respectively. The structures of the first main body and the first current collecting unit have been described above and will not be repeated here. The third current collecting unit has a same structure as that of the second current collecting unit. That is, there are a current collecting unit in a linear form at one end of the first main body, and a current collecting unit in a V-shaped or a U-shaped form at another end of the first main body.

In some embodiments, the second busbar includes a second main body, a second current collecting unit, and a fourth current collecting unit. Along the second direction, the second current collecting unit and the fourth current collecting unit are located at two ends of the second main body, respectively. The structures of the second main body and the second current collecting unit have been described above and will not be repeated here. The fourth current collecting unit has a same structure as that of the first current collecting unit. That is, there are a current collecting unit in a linear form at one end of the second main body, and a current collecting unit in a V-shaped or a U-shaped form at another end of the second main body.

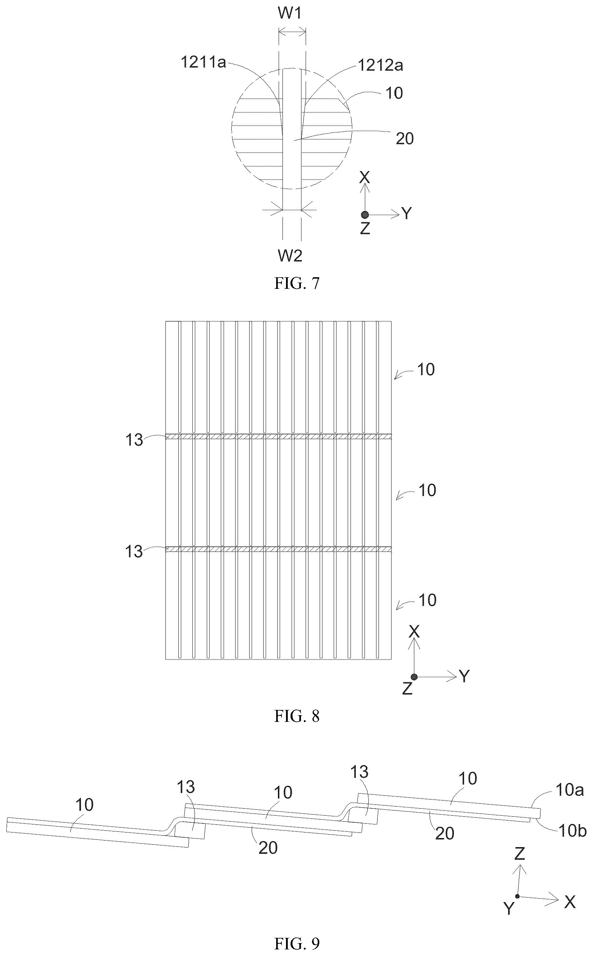

As shown in FIG. 6 and FIG. 7, in one or more embodiments, the maximum distance between the first current collecting segment 1211 and the second current collecting segment 1212 is W1, the width of the solder strip 20 is W2, and W1 and W2 satisfy: W1>W2.

There are a first end 1211a at an end of the first current collecting segment 1211 away from the second main body 122, and a second end 1212a at an end of the second current collecting segment 1212 away from the second main body 122. The first end 1211a and the second end 1212a are located at the edge of the solar cell 10. When the solder strip 20 is connected to the second busbar 12, the solder strip 20 is located between the first end 1211a and the second end 1212a. Since the width W2 of the solder strip 20 is smaller than the maximum distance W1 between the first current collecting segment 1211 and the second current collecting segment 1212, there is a certain spacing between the solder strip 20 and the first end 1211a as well as the second end 1212a. That is, along the second direction Z, the projections of the first end 1211a and the second end 1212a are located outside the projection of the solder strip 20. Since there is a certain spacing between the solder strip 20 and the first end 1211a of the first current collecting segment 1211 as well as the second end 1212a of the second current collecting segment 1212, the first end 1211a and the second end 1212a are prevented from melting at high temperature and being alloyed with the solder strip 20 during soldering of the solder strip 20. That is, the solder strip 20 is not connected to the first end 1211a or the second end 1212a, allowing the edge of the solar cell 10 to not be fixed by the solder strip 20, thereby reducing the risk of hidden cracks even breakage in the solar cell 10 caused by stress concentration at the edge of the solar cell 10, and improving the overall reliability of the photovoltaic module 1000.

In some embodiments, the minimum distance between the first current collecting segment and the second current collecting segment is W3, the width of the solder strip is W2, and W3 and W2 satisfy: W3>W2. By this design, the spacing between the first current collecting segment and the solder strip as well as the spacing between the second current collecting segment and the solder strip are both further increased, thus the first current collecting segment and the second current collecting segment are prevented from melting at high temperature and being alloyed with the solder strip during soldering of the solder strip, allowing the edges of the solar cell to not be fixed by the solder strip, thereby reducing the risk of hidden cracks even breakage in the solar cell caused by stress concentration at the edge of the solar cell, and improving the overall reliability of the photovoltaic module.

In some embodiments, the two adjacent solar cells are respectively a first solar cell and a second solar cell. The solder strip is soldered to the first main body and the first current collecting unit of the first busbar of the first solar cell, and to the second main body of the second busbar of the second solar cell. The projection of the second current collecting unit of the second busbar is located outside the projection of the solder strip corresponding thereto. Therefore, the solder strip is not soldered to the second current collecting unit. The first current collecting unit on the first surface of the solar cell is soldered to the solder strip, enabling the current collected by the first current collecting unit to be directly transmitted to the solder strip, thereby reducing the current transmission path, lowering current transmission loss, and improving the photovoltaic conversion efficiency of the photovoltaic module. The second current collecting unit on the second surface of the solar cell is not soldered to the solder strip, allowing the edge of the second surface of the solar cell to not be fixed by the solder strip, reducing the risk of stress concentration at the edge of the solar cell during lamination, testing, transportation and other processes, thereby reducing the risk of hidden cracks even breakage in the solar cell, and improving the overall reliability of the photovoltaic module.

As shown in FIG. 2, in one or more embodiments, the photovoltaic module 1000 includes a buffer 13. Along the second direction Z, the buffer 13 is provided between the two adjacent solar cells 10.

The buffer 13 serves a buffering function. The buffer 13 is located at the overlap of two adjacent solar cells 10 to avoid hard contact between the two adjacent solar cells 10, thereby reducing the risk of stress concentration at the overlap of the two adjacent solar cells 10, and consequently reducing the risk of hidden cracks or breakage in the solar cell 10 during lamination and subsequent application, and improving the reliability of the photovoltaic module 1000.

In some embodiments, the buffer includes one or more of ethylene-vinyl acetate (EVA), polyolefin elastomer (POE), and polyvinyl butyral (PVB).

As shown in FIG. 2, in one or more embodiments, along the second direction Z, the projection area of the buffer 13 is larger than the overlap area of the projections of the two adjacent solar cells 10. That is, the buffer 13 extends from the overlap of the two adjacent solar cells 10. By increasing the effective area of the buffer 13, the buffer 13 reliably serves a buffering function between the solar cells 10, reducing the risk of stress concentration at the overlap of the two adjacent solar cells 10, thereby reducing the risk of hidden cracks or breakage in the solar cells 10.

As shown in FIG. 8, in one or more embodiments, the length of the buffer 13 is the same as the length of the solar cell 10, which increases the effective area of the buffer 13 to improve the reliability of the buffer 13.

The thickness D of the buffer 13 (i.e., the size of the buffer 13 along the second direction Z) satisfies: 50 µm ≤ D ≤ 200 µm. For example, D may be 50 µm, 60 µm, 80 µm, 100 µm, 120 µm, 140 µm, 160 µm, 180 µm, or 200 µm, and or other value within the above range. If the thickness of the buffer 13 is too small, for example, D < 50 µm, the buffering effect of the buffer 13 is weakened, and the risk of stress concentration at the overlap of the two adjacent solar cells 10 increases, which result in an increased risk of hidden cracks and breakage in the solar cells 10, affecting the reliability of the photovoltaic module 1000. If the thickness of the buffer 13 is too large, for example, D > 200 µm, the thickness of the solar cell string increases, that is, the thickness of the photovoltaic module 1000 increases, affecting the mechanical properties and reliability of the photovoltaic module 1000. Therefore, by setting the thickness of the buffer 13 within the range of 50 µm ≤ D ≤ 200 µm, the buffering effect of the buffer 13 is enhanced while keeping the thickness of the photovoltaic module 1000 within a reasonable range, thereby ensuring the overall stability and reliability of the photovoltaic module 1000.

As shown in FIG. 2 and FIG. 9, in one or more embodiments, the two adjacent solar cells 10 are respectively a first solar cell and a second solar cell. The buffer 13 is provided at a side of the solder strip 20 facing the second surface 10b of the first solar cell, and/or, the buffer 13 is provided at a side of the solder strip 20 facing the first surface 10a of the second solar cell.

As mentioned above, the solar cell 10 is a segmented cell. In some embodiments, the first solar cell and the second solar cell are obtained by cutting whole cells into half-segmented cell, three-segmented cell, or four-segmented cell. Along the second direction Z, the buffer 13 is provided at a side of the solder strip 20. In some embodiments, as shown in FIG. 2, when the buffer 13 is provided at the side of the solder strip 20 facing the second surface 10b of the first solar cell, along the second direction Z, the upper end surface of the buffer 13 is connected to the second surface 10b of the first solar cell, and the lower end surface of the buffer 13 is connected to the solder strip 20 connected to the first surface 10a of the second solar cell. In combination with FIG. 3 to FIG. 6, the buffer 13 covers the second current collecting unit 121 of the second surface 10b of the first solar cell, enabling the solder strip 20 to be soldered to the second main body 122 of the second busbar 12 without to the second current collecting unit 121 of the second busbar 12. Furthermore, the solder strip 20 is soldered to the first main body 112 and the first current collecting unit 111 of the first busbar 11 of the first solar cell.

As shown in FIG. 9, when the buffer 13 is provided at the side of the solder strip 20 facing the first surface 10a of the second solar cell, along the second direction Z, the upper end surface of the buffer 13 is connected to the solder strip 20 connected to the second surface 10b of the first solar cell, and the lower end surface of the buffer 13 is connected to the first surface 10a of the second solar cell. In combination with FIG. 3 to FIG. 6, the solder strip 20 covers the first current collecting unit 111 of the first surface 10a of the second solar cell, enabling the solder strip 20 to be soldered to the first main body 112 of the first busbar 11 without to the first current collecting unit 111. Furthermore, the solder strip 20 is soldered to the second main body 122 of the second busbar 12 of the first solar cell without to the second current collecting unit 121 of the second busbar 12.

The buffer 13 is provided at a side of the solder strip 20 to avoid hard contact between the two adjacent solar cells 10, thereby reducing the risk of stress concentration at the overlap of the two adjacent solar cells 10, and consequently reducing the risk of the buffer 13 interfering with the connection between the solder strip 20 and the busbar, to improve the reliability of the photovoltaic module 1000.

In other one or more embodiments, along the second direction, buffer is provided at two sides of the solder strip to further enhance the buffering effect of the buffers and reduce the risk of stress concentration at the overlap of the two adjacent solar cells.

During manufacture of the photovoltaic module, the buffer is pre-provided on the first surface and/or the second surface of the solar cell, and then the two adjacent solar cells are connected by the solder strips through using a solar cell stringer to form a solar cell string. Alternatively, the two adjacent solar cells is connected firstly by the solder strips through using a solar cell stringer to form a solar cell string, and then the buffer is provided at the side(s) of the solder strip facing the first surface and/or the second surface of the solar cell.

The above descriptions are only optional embodiments of the present disclosure and are not intended to limit the present disclosure, and various modifications and changes may be made by those skilled in the art. The scope of the present disclosure shall be defined by the appended claims.

## Claims

1. A photovoltaic module (1000), **characterized in that** the photovoltaic module (1000) comprises:
a solar cell (10), wherein a plurality of solar cells (10) are arranged along a first direction, and there is overlap between projections of two adjacent solar cells (10) along a second direction; and
a solder strip (20), wherein the two adjacent solar cells (10) are connected by the solder strip (20),
wherein the solar cell (10) comprises a first surface (10a) and a second surface (10b) along the second direction, a first busbar (11) is provided on the first surface (10a) and comprises a first current collecting unit (111), a second busbar (12) is provided on the second surface (10b) and comprises a second current collecting unit (121), and wherein along the second direction, a projection area of the first current collecting unit (111) is smaller than a projection area of the second current collecting unit (121), and a projection of the first current collecting unit (111) is located within a projection of the solder strip (20) corresponding thereto.

2. The photovoltaic module (1000) according to claim 1, **characterized in that** the first busbar (11) comprises a first main body (112) connected to the solder strip (20), and the first current collecting unit (111) is connected to at least one end of the first main body (112); and
the projection of the first current collecting unit (111) along the second direction exhibits a linear form, and an arrangement direction of the first current collecting unit (111) is the same as an arrangement direction of the first main body (112).

3. The photovoltaic module (1000) according to claim 2, **characterized in that** the first current collecting unit (111) is connected to two ends of the first main body (112), and the first current collecting unit (111) and the first main body (112) are connected to the same solder strip (20).

4. The photovoltaic module (1000) according to claim 1, **characterized in that** the first busbar (11) and the second busbar (12) are arranged at intervals along a third direction, wherein the third direction is a length direction of the solar cell (10).

5. The photovoltaic module (1000) according to claim 1, **characterized in that** along the second direction, a projection of at least part of the second current collecting unit (121) is located outside a projection of the solder strip (20) corresponding thereto.

6. The photovoltaic module (1000) according to claim 1, **characterized in that** both the first current collecting unit (111) and the second current collecting unit (121) are provided at edge of the solar cell (10).

7. The photovoltaic module (1000) according to claim 3, **characterized in that** the second busbar (12) comprises a second main body (122) connected to the solder strip (20), and the second current collecting unit (121) is connected to at least one end of the second main body (122), and
wherein the second current collecting unit (121) comprises a first current collecting segment (1211) and a second current collecting segment (1212) that are connected to each other, and a distance between the first current collecting segment (1211) and the second current collecting segment (1212) gradually increases in a direction away from the second main body (122).

8. The photovoltaic module (1000) according to claim 7, **characterized in that** the second current collecting unit (121) is connected to at least one end of the second main body (122) along the first direction, and wherein the arrangement direction of the second main body (122) is different from the arrangement direction of the first current collecting segment (1211) or the arrangement direction of the second busbar (12).

9. The photovoltaic module (1000) according to claim 1, **characterized in that** the first busbar (11) comprises a first main body (112), a first current collecting unit (111), and a third current collecting unit, wherein along the second direction, the first current collecting unit (111) and the third current collecting unit are connected to two ends of the first main body (112), respectively, and wherein the third current collecting unit has a same structure as a structure of the second current collecting unit (121).

10. The photovoltaic module (1000) according to claim 1, **characterized in that** the second busbar (12) comprises a second main body (122), a second current collecting unit (121), and a fourth current collecting unit, wherein along the second direction, the second current collecting unit (121) and the fourth current collecting unit are located at two ends of the second main body (122), respectively, and wherein the fourth current collecting unit has a same structure as a structure of the first current collecting unit (111).

11. The photovoltaic module (1000) according to claim 7, **characterized in that** the maximum distance between the first current collecting segment (1211) and the second current collecting segment (1212) is W1, a width of the solder strip (20) is W2, and W1 and W2 satisfy: W1>W2.

12. The photovoltaic module (1000) according to any one of claims 1 to 11, **characterized in that** the photovoltaic module (1000) comprises a buffer (13), and along the second direction, the buffer (13) is provided between the two adjacent solar cells (10).

13. The photovoltaic module (1000) according to claim 12, **characterized in that** along the second direction, a projection area of the buffer (13) is larger than an overlap area of the projections of the two adjacent solar cells (10).

14. The photovoltaic module (1000) according to claim 13, **characterized in that** a length of the buffer (13) is the same as a length of the solar cell (10), and a thickness D of the buffer (13) satisfies: 50 µm ≤ D ≤ 200 µm.

15. The photovoltaic module (1000) according to claim 14, **characterized in that** the two adjacent solar cells (10) are respectively a first solar cell (10) and a second solar cell (10); and
the buffer (13) is provided at a side of the solder strip (20) facing the second surface (10b) of the first solar cell (10), and/or the buffer (13) is provided at a side of the solder strip (20) facing the first surface (10a) of the second solar cell (10).
